# EUROPÄISCHE PATENTSCHRIFT

(11) **EP 0 944 297 B1**
(45) Veröffentlichungstag und Bekanntmachung des Hinweises auf die Patenterteilung: **02.06.2004**
(21) Anmeldenummer: 99103871.2
(22) Anmeldetag: 01.03.1999
(51) Int. Cl.: H05K 7/20, H02B 1/56

(54) **Geräteschrank**
Equipment cabinet
Armoire pour appareillage

(30) Priorität: 19.03.1998 DE 19812117
(43) Veröffentlichungstag der Anmeldung: 22.09.1999
(73) Patentinhaber: Knürr AG, 94424 Arnstorf (DE)
(72) Erfinder: Bretschneider, Rainer, 01662 Meissen (DE); Schwäbe, Jörg, 01683 Gruna (DE); Willkommen, Thomas, Dr., 01662 Meissen (DE)
(74) Vertreter: Heim, Hans-Karl, Dipl.-Ing.

(56) Entgegenhaltungen:
- DE-A- 2 844 672
- US-A- 5 529 120

## Beschreibung

Die Erfindung betrifft einen Geräteschrank für elektrische und elektronische Geräte und Bauteile gemäß dem Oberbegriff des Anspruchs 1.

Aus der WO 97/48261 ist ein Geräteschrank bekannt, welcher als Schalt- oder Steuerschrank verwendet wird. Ein Funktionsraum ist staub- und wasserdicht ausgebildet und von einer mehrschaligen Wand und wenigstens einer staub- und wasserdicht schließenden Tür umgeben. Der Geräteschrank ist für unterschiedliche Klimazonen ausgelegt und weist eine Funktionsraumwand, welche zwischen einer Außenwand und einer innenseitigen Leitwand angeordnet und mit einer Berippung, beispielsweise in Form von Nadeln, versehen ist, auf. Die Berippung ragt in einen Innenkanal, welcher von der Funktionsraumwand und der von Leitflächen oder Seitenwänden von Einschüben gebildeten innenseitigen Leitwand begrenzt wird, und in einen Außenkanal, welcher zwischen der Funktionsraumwand und der Außenwand ausgebildet.ist.

Ein erster Fluidstrom wird im Kreislauf durch den Funktionsraum und den Innenkanal mit Hilfe wenigstens eines Lüfters geführt und an der Funktionsraumwand mit Berippung abgekühlt. Die Kühlung der Funktionsraumwand und der wärmeleitend eingebrachten Nadeln erfolgt mit einem in dem Aussenkanal strömenden äußeren Fluidstrom, insbesondere einem Kalt- oder Umgebungsluftstrom, welcher lastabhängig durch wenigstens einen Lüfter angesaugt wird und im Bereich einer Schrankabdeckung austritt.

Die in den Innen- und Außenkanal ragenden Nadeln vergrößern die Oberfläche der Funktionsraumwand und verbessern den konvektiven Wärmeübergang und damit die Kühlung oder Temperierung des Funktionsraums.

Der bekannte Geräteschrank gewährleistet eine steuerbare Wärmeableitung ohne kosten- und platzaufwendige Kühlgeräte. Kostenerhöhend wirkt sich jedoch die Herstellung der Berippung aus. Die Nadeln weisen aus thermohydraulischen Gründen in der Regel einen Durchmesser von weniger als einen bis wenigen Millimetern auf und müssen mit einer hohen Besetzungsdichte, d.h. mit einer Quer- und Längsteilung im Millimeterbereich, in die Funktionsraumwand eingebracht werden. Da die Funktionsraumwand in der Regel als eine EMV-abgeschirmte, staub- und wasserdampfdichte Wand ausgebildet ist, besteht die Gefahr, daß durch die Berippung, beispielsweise beim Durchstecken der Nadeln, die erforderliche Dichtigkeit und EMV-Abschirmung nicht mehr gewährleistet ist.

Der Erfindung liegt die **Aufgabe** zugrunde, einen Geräteschrank zu schaffen, bei welchem eine Kühlung und Temperierung eines Funktionsraums mit Hilfe einer Berippung außerordentlich effizient erfolgt und welcher gleichzeitig kostengünstig hergestellt und betrieben werden kann.

Erfindungsgemäß wird die Aufgabe durch die Merkmale des Anspruchs 1 gelöst. Zweckmäßige und vorteilhafte Ausgestaltungen sind in den Unteransprüchen und in den Ausführungsbeispielen angegeben.

Ein wesentlicher Grundgedanke der Erfindung ist darin zu sehen, die vorteilhafte Berippung kostengünstig und ohne nachteiligen Folgen für eine Funktionsraumwandung zu gestalten.

Erfindungsgemäß wird eine Vielzahl von Rippen und Durchgangsöffnungen, welche zu einer Verwirbelung einer Fluidströmung und zu einem besseren Wärmeübergang führen, an einem leisten- oder schienenförmigen Element ausgebildet, welches vorgefertigt ein- oder zweckmäßigerweise beidseitig einer Funktionsraumwand angebracht werden kann.

Ein Vorteil der erfindungsgemäßen Rippenschienen oder -leisten besteht darin, daß sie eine Vielzahl von Rippen und Durchgangsöffnungen aufweisen und über wenige Durchbohrungen in der Funktionsraumwandung oder z.B. mittels Kleben, Schweißen, Löten oder auch Toxen an dieser befestigt werden können.

Die Rippenschienen können grundsätzlich in jeder Richtung, d.h. vertikal, horizontal oder schräg angeordnet werden. In der Regel ist es zweckmäßig, sie in einer horizontalen Anordnung an der Innen- und/oder Außenseite einer Funktionsraumwand zu befestigen. Um einen besonders guten Wärmeübergang zu erreichen, kann die Funktionsraumwand nahezu über ihre gesamte Höhe und Breite mit Rippenschienen versehen werden, wobei die einzelnen Rippenschienen eine einheitliche oder unterschiedliche Länge aufweisen und aneinandergereiht werden können oder an die Höhe oder Breite einer Funktionsraumseitenwand und einer Funktionsraumrückwand angepaßt sind.

Das schienen- oder leistenförmige Berippungselement mit einer Vielzahl von Rippen und Durchgangsöffnungen ist in einer besonders vorteilhaften Variante als ein U-Profil ausgebildet und kann kostengünstig aus einem Blechzuschnitt hergestellt werden, welches nur einem Stanz- und Biegeprozeß unterzogen werden muß.

U-förmig ausgebildete Rippenschienen weisen in horizontaler Anordnung einen unteren und oberen Schienenschenkel mit Rippen und Durchgangsöffnungen sowie einen Mittelsteg auf, welcher in einer vertikalen Ausrichtung wärmeleitend an der Innen- und/oder Außenseite der Funktionsraumwand anliegt.

Die Rippenschienen können mit einem beliebigen Abstand über- oder nebeneinander angeordnet werden. Es kann sinnvoll sein, den Abstand der Höhe des Mittelstegs anzupassen.

Ein weiterer Vorteil der Rippenschienen besteht darin, daß eine Vielzahl von Formen und Anordnungen der Rippen und Durchgangsöffnungen möglich ist, mit denen eine besonders gute Verwirbelung und ein hoher Wärmeübergangskoeffizient an der Funktionsraumwand erzielt werden kann. Die Rippenund Durchgangsöffnungen des unteren und oberen Schienenschenkels können miteinander fluchtend oder aber versetzt zueinander ausgebildet sein. Die Durchgangsöffnungen können durch Ausstanzungen oder durch Schlitze bzw. Schnitte und nachfolgende Biegungen um eine Drehachse gebildet werden. Des weiteren können etwa rechteckige Stanzbereiche kiemenartig um eine längsseitige Biegekante auf- oder auch abgebogen bzw. auf- oder abgewinkelt werden. Die Durchgangsöffnungen sind dann vorteilhafterweise mit Richtungsstegen versehen, welche eine gezielte Verwirbelung und verbesserte Kühlung bzw. Temperierung gewährleisten.

Die Abmessungen der U-förmigen Rippenschiene, insbesondere die Breite der horizontal angeordneten Schienenschenkel ist von den Abmessungen des Innen- und/oder Außenkanals des Geräteschrankes und der erforderlichen Kühlleistung bestimmt. Die Schienenschenkel können bis zu der innenseitigen Leitwand bzw. zur Außenwand reichen und eine besonders gute Wärmeabführung gewährleisten.

Die Breite der Schienenschenkel der einzelnen Rippenschienen kann über die Höhe eines Geräteschrankes variieren und auf die Bestückung des Funktionsraumes abgestimmt werden.

Neben einer U- oder auch C-förmigen Rippenschiene oder Rippenleiste kann auch eine L-förmige Rippenschiene oder -leiste eingesetzt werden, welche an einem vertikalen Befestigungssteg nur einen Schienenschenkel mit Rippen und Durchgangsöffnungen aufweist.

Eine U- oder C-förmige Rippenschiene kann auch als eine Doppelrippenschiene ausgebildet sein und zusätzlich zu den Rippen, welche von den Schienenschenkeln gebildet werden, Mittelrippen aufweisen. Rippen und Mittelrippen werden ebenfalls durch einen einfachen Stanz- und Biegevorgang gebildet, und die Befestigung der Doppelrippenschiene erfolgt wiederum vorteilhafterweise im Bereich eines Mittelstegs.

In einer besonders kostengünstigen Ausbildung können U-förmige oder L-förmige Rippenschienen aus einem Lochblech gefertigt werden. Das Lochblech kann beliebige Lochformen als Durchgangsöffnungen und Stege als Rippen aufweisen. Dabei können die Löcher eines Schienenschenkels mit denen des darunter und darüber angeordneten Schienenschenkels fluchten oder versetzt zu diesen ausgebildet sein. Der Mittelsteg kann lochfrei oder aber ebenfalls mit Löchern versehen sein. Anstelle eines Lochblechs kann auch ein Siebgewebe, inbesondere im Bereich der Schienenschenkel verwendet werden.

Rippenschienen, welche bevorzugt für eine vertikale Anordnung geeignet sind, weisen in Strömungsrichtung versetzte Rippen auf, welche durch Randausnehmungen, beispielsweise Randschlitze, gebildet sind, wobei diese Randausnehmungen bis zu einer versetzten Biegekante reichen. Als Durchgangsöffnungen sind die Räume zwischen den Breitseiten der Rippen ausgebildet, und die Rippenabstände quer zur Strömungsrichtung sind unterschiedlich. Die Rippenschiene ist dann stufenförmig und nicht als eine ebene Schiene ausgebildet und kann unterschiedlich hohe Rippen und durch die Randausnehmungen gebildete Schlitze aufweisen.

Eine weitere Variante einer Rippenschiene weist einen Befestigungssteg auf, welcher nahezu über die gesamte Breite einer Funktionsraumwand reicht und mit einer Vielzahl von Stiften als Rippen versehen ist. Die Stifte können durch einen Fügeprozeß an dem Befestigungssteg, welcher plattenförmig ausgebildet ist, befestigt werden. Die Stifte können auch nagelartig ausgebildet sein und unterschiedliche Querschnitte, z.B. einen kreisrunden, quadratischen, rechteckigen oder polygonalen Querschnitt, aufweisen.

Die Stifte können auch stromlinienförmig ausgebildet sein und fluchtend oder versetzt, mit gleicher oder unterschiedlicher Quer- und Längsteilung an dem Befestigungssteg fixiert sein.

Die erfindungsgemäße Rippenschiene ist nicht auf den Einsatz in Geräteschränken beschränkt, sondern kann für Gehäuse und Baugruppenträger, welche insbesondere eine lastabhängige Kühlung aufweisen, eingesetzt werden. Die Rippenschiene kann auch an Einrichtungen mit ein- oder zweiteiligen Begrenzungswänden eingesetzt werden, um eine kostengünstige, effiziente Wärmeabführung zu erreichen. Ein weiteres vorteilhaftes Einsatzgebiet sind Wärmetauscher.

Die Erfindung wird nachstehend anhand einer Zeichnung weiter erläutert; in dieser zeigen in einer stark schematisierten Darstellung
- Fig. 1: einen Längsschnitt durch einen erfindungsgemäßen Geräteschrank;
- Fig. 2: eine Draufsicht auf eine Rippenschiene nach dem Stanzen und vor dem Biegen;
- Fig. 3: eine Draufsicht auf eine Rippenschiene gemäß Fig. 2 nach dem Stanz- und Biegeprozeß;
- Fig. 4: eine Seitenansicht der Rippenschiene nach Pfeil IV gemäß Fig. 3;
- Fig. 5: eine Ansicht der Rippenschiene nach Pfeil V gemäß Fig. 3 oder Fig. 4;
- Fig. 6: eine Draufsicht auf einen Ausschnitt einer Rippenschiene nach dem Einbringen von Schlitzen und vor dem Biegeprozeß;
- Fig. 7: eine Ansicht der Rippenschiene nach Pfeil VII gem. Fig. 6, jedoch nach dem Biegeprozeß;
- Fig. 8: eine Draufsicht auf einen Ausschnitt einer Rippenschiene nach dem Stanzen und vor dem Biegeprozeß;
- Fig. 9: eine Draufsicht auf die Rippenschiene nach Pfeil IX gemäß Fig. 8, jedoch nach dem Biegeprozeß;
- Fig. 10: eine Draufsicht auf eine weitere Variante einer Rippenschiene nach dem Stanzprozeß und vor dem Biegeprozeß;
- Fig. 11: eine Draufsicht auf ein Lochblech für eine Rippenschiene vor dem Biegeprozeß;
- Fig. 12: eine Draufsicht auf eine weitere Variante einer Profilschiene nach dem Stanzen und vor dem Biegeprozeß;
- Fig. 13: eine Seitenansicht einer Profilschiene nach Linie XIII-XIII gemäß Fig. 14;
- Fig. 14: zwei nebeneinander angeordnete Profilschienen gemäß Fig. 12 nach dem Biegeprozeß;
- Fig. 15: eine Draufsicht auf eine weitere Variante einer Rippenschiene mit einem Befestigungssteg und fluchtend angeordneten Rippen;
- Fig. 16: eine Draufsicht auf eine Rippenschiene analog zu Fig. 15, jedoch mit versetzt angeordneten Rippen;
- Fig. 17: eine Draufsicht auf einen Ausschnitt einer Rippenschiene analog zur Fig. 15 und 16, jedoch mit stromlinienförmig ausgebildeten Rippen;
- Fig. 18: eine Draufsicht auf eine sogenannte "Doppelrippenschiene" nach dem Stanzen und vor dem Biegen;
- Fig. 19: eine Draufsicht auf die Doppelrippenschiene gemäß Fig. 18 nach dem Biegen und
- Fig. 20: eine Seitenansicht der Doppelrippenschiene gemäß XX -XX der Fig. 18.

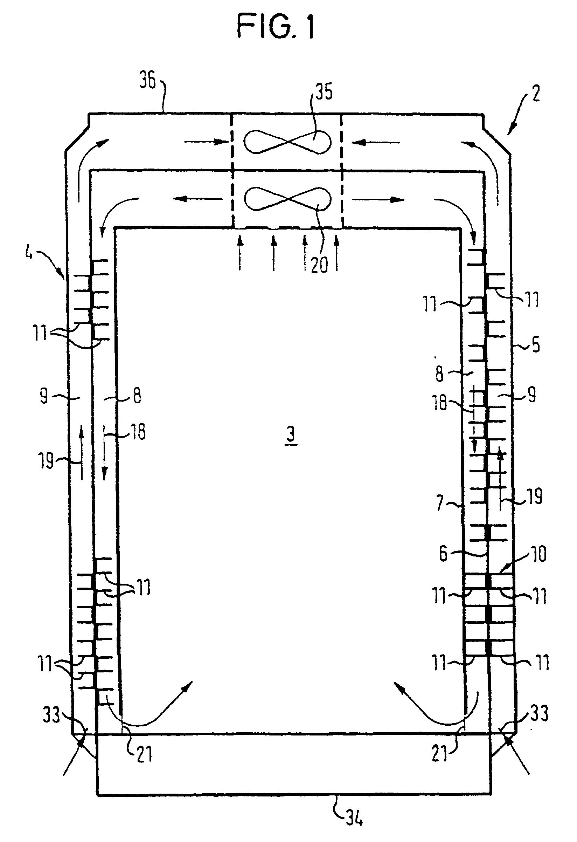

Fig. 1 zeigt einen Geräteschrank 2 mit einem Funktionsraum 3, welcher von einer Wand 4 und wenigstens einer Tür (nicht dargestellt) umgeben und staub- und wasserdicht sowie EMVabgeschirmt ausgebildet ist.

Die Wand 4 ist mehrschalig ausgebildet und weist eine Außenwand 5, eine Funktionsraumwand 6 und eine innenseitige Leitwand 7 auf, welche von Leitblechen (nicht dargestellt) und/oder von Seitenwänden von Einschüben (nicht dargestellt) gebildet sein kann. Zwischen der innenseitigen Leitwand 7 und der Funktionsraumwand 6 ist ein Innenkanal 8 für einen zirkulierenden Fluidstrom 18 ausgebildet, welcher mit Hilfe eines Sauglüfters 20 über bodenseitige Eintrittsöffnungen 21 durch den Funktionsraum 3 geleitet wird, um die von Geräten, Baugruppen und dergleichen (nicht dargestellt) erzeugte Wärme abzuführen.

Eine Abkühlung bzw. Temperierung des Fluidstroms 18 erfolgt im Bereich der Funktionsraumwand 6, welche mit einer Berippung 10 versehen ist. Die Berippung 10 der Funktionsraumwand 6 erfolgt mit Rippenschienen 11, welche U-förmig ausgebildet und in einer waagerechten Anordnung an der Innen- und Außenseite der Funktionsraumwand 6 befestigt sind.

Die beispielhaft dargestellten und angeordneten Rippenschienen 11 in dem linken und rechten Innenkanal 8 und Außenkanal 9 zeigen mögliche Varianten. Die linke Seite des Geräteschrankes 2 weist versetzt angeordnete Rippenschienen 11 auf, welche nicht den gesamten Querschnitt des Innenkanals 8 und des Außenkanals 9 einnehmen, sondern beabstandet zur innenseitigen Leitwand 7 bzw. zur Außenwand 5 angeordnet sind.

Die Rippenschienen 11 im unteren Bereich des rechten Innenkanals 8 und Außenkanals 9 sind in gleicher Höhe an der Funktionsraumwand 6 befestigt und reichen bis zu der innenseitigen Leitwand 7 bzw. zur Außenwand 5. Durch den direkten Kontakt wird neben einer Verwirbelung des Fluidstroms eine zusätzliche Wärmeleitung erreicht, welche eine besonders gute Kühlung des Fluidstroms 18 im Innenkanal 8 bewirkt. Die in einem oberen Bereich angeordneten Rippenschienen 11 im rechten Innenkanal 8 und Außenkanal 9 sind mit unterschiedlichen Abständen und versetzt zueinander angeordnet.

In der Regel werden die Rippenschienen in den Innenkanälen 8 und Außenkanälen 9 der Funktionsraumseitenwände und einer Funktionsraumrückwand einheitlich ausgebildet und angeordnet sein. Grundsätzlich besteht jedoch die Möglichkeit, unterschiedlich ausgebildete Rippenschienen 11 an der Funktionsraumwand 6 zu befestigen und die Abstände der Rippenschienen 11 voneinander über die Höhe des Geräteschranks 2 zu variieren und beispielsweise auf die Bestückung des Funktionsraums 3 abzustimmen.

Die Abkühlung der Funktionsraumwand 6 mit ihren innen- und außenseitigen Rippenschienen 11 erfolgt durch einen Fluidstrom 19, welcher über verschließbare Öffnungen 33 nahe eines Schranksockels 34 mit Hilfe eines Sauglüfters 35 angesaugt und durch den Außenkanal 9 von unten nach oben und durch die Rippenschienen 11 geführt wird. Die Sauglüfter 20, 35 können lastabhängig gesteuert werden, so daß die Volumenströme 18, 19 im Innenkanal 8 und Außenkanal 9 entsprechend der abzuführenden Wärmemenge des Funktionsraums 3 und der Temperatur der im Außenkanal 9 geführten Umgebungsluft eingestellt werden können. Die Kühlluft im Außenkanal 9 kann zusätzlich über Lamellen (nicht dargestellt) in einer Abdeckung 36 des Geräteschrankes 2 abgeführt werden. Innen- und/oder Außenkanal 8, 9 können zur Isolierung auch ohne Luft- bzw. Fluidzirkulation betrieben werden.

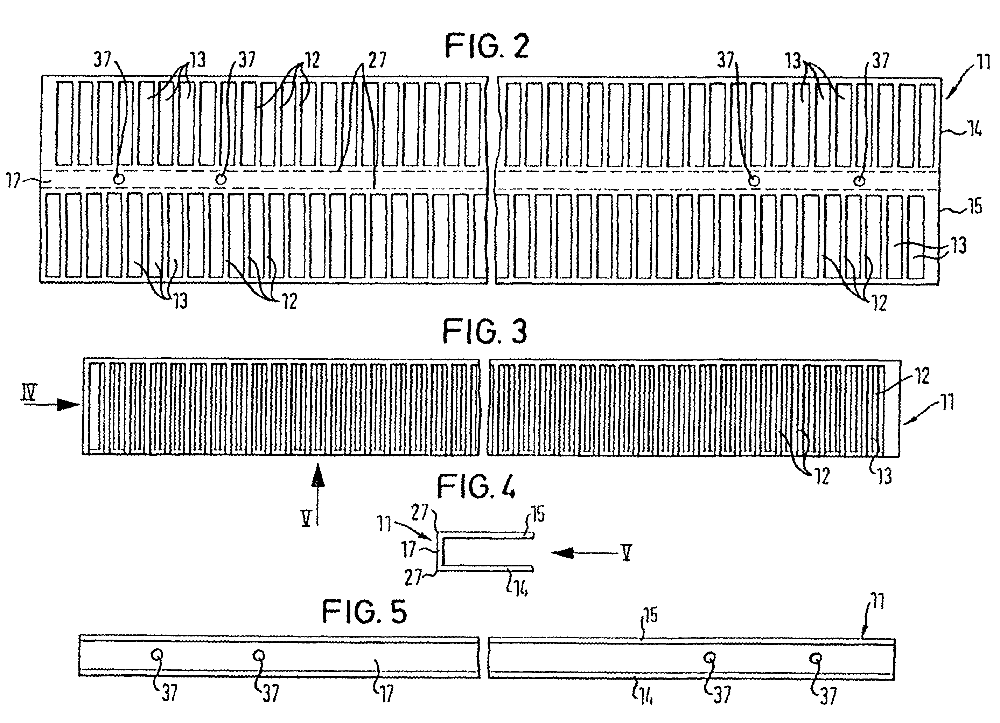

Die Fig. 2 bis 5 zeigen eine bevorzugte Ausbildung einer Rippenschiene 11, welche in Fig. 2 in einer vergrößerten Darstellung nach einem Stanzprozeß, jedoch noch vor einem Biegeprozeß dargestellt ist.

Die Profilschiene 11 ist als ein U-Profil ausgebildet und weist eine Vielzahl von Rippen 12 und Durchgangsöffnungen 13 auf. Die Rippen 12 und Durchgangsöffnungen 13, welche in diesem Beispiel durch Ausstanzungen gebildet sind, sind in einem unteren Schienenschenkel 14 im Vergleich zu einem oberen Schienenschenkel 15 versetzt angeordnet, wodurch eine stärkere Verwirbelung des Fluidstroms und ein besserer Wärmeaustausch erreicht werden. Die Befestigung der als U-Profil ausgebildeten Rippenschiene 11 erfolgt im Bereich eines Mittelstegs 17, welcher vertikal ausgerichtet ist und an der Außen- oder Innenseite der Funktionsraumwand 6 anliegt. Im vorliegenden Ausführungsbeispiel wird die Rippenschiene 11 über vier Befestigungsbereiche 37 (siehe Figur 2 und 5) befestigt.

Die ausgestanzte Profilschiene 11 gemäß Fig. 2 zeigt strichliert die späteren Biegekanten 27. Die Darstellungen gemäß Fig. 2 und 3 verdeutlichen, daß die Durchgangsöffnungen 13 über nahezu die gesamte Breite der Schienenschenkel 14, 15 reichen. In den Schienenschenkeln 14, 15 können abweichend auch ein oder mehrere Querstege ausgebildet werden, wenn dies aus thermohydraulischer Sicht vorteilhaft ist.

Aus Fig. 4 kann abgeleitet werden, daß die Profilschiene 11 auch L-förmig oder C-förmig ausgebildet werden kann.

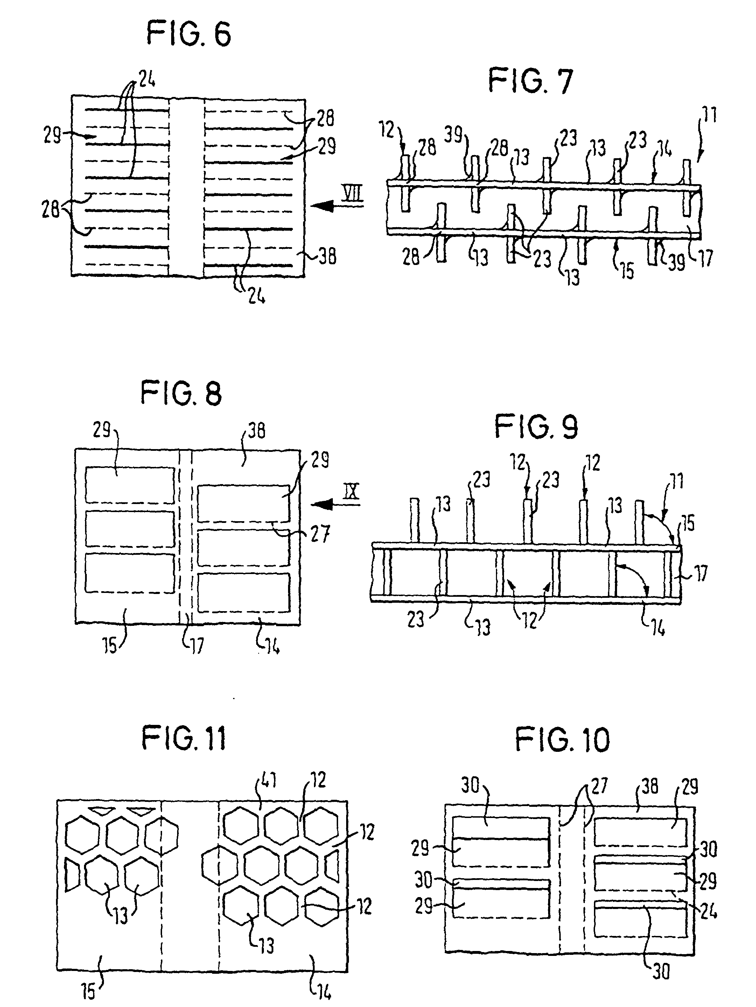

Die nachfolgenden Figuren 6 bis 17 zeigen weitere Ausbildungsvarianten einer Rippenschiene 11. Der in Fig. 6 dargestellte Ausschnitt eines zugeschnittenen Blechs 38 für eine Rippenschiene 11 weist Schlitze oder Schnitte 24 auf. In einem nachfolgenden Biegeprozeß werden Stanzbereiche 29 zwischen den Schlitzen oder Schnitten 24 um eine Drehachse 28 in Strömungsrichtung gedreht und Richtungsstege 23 als Rippen 12 nahezu vertikal ausgerichtet (Fig. 7). Eine besonders gute Verwirbelung wird durch die versetzte Ausbildung der Durchgangsöffnungen 13 und der Richtungsstege 23 erreicht. Durch die Schlitze bzw. Schnitte 24 sind im Bereich der Durchgangsöffnungen 13 Seitenstege 39 gebildet.

Nach Fig. 8 wird ein Blech 38 für eine Profilschiene 11 mit Rippen 12 und Durchgangsöffnungen 13 gemäß Fig. 9 mit Stanzbereichen 29 versehen, welche um eine Biegekante 27 kiemenartig aufgebogen werden. Die derart ausgebildeten Richtungsstege 23 als Rippen 12 und die Durchgangsöffnungen 13 an den unteren Schienenschenkel 14 und dem oberen Schienenschenkel sind wieder versetzt angeordnet und weisen einen Öffnungswinkel von nahezu 90° auf.

Fig. 10 zeigt eine weitere Variante eines Blechs 38 für eine Rippenschiene 11. Die durch eine Stanzung gebildeten Stanzbereiche 29 weisen außerdem Ausstanzungen 30 auf, so daß sie nach dem Biegeprozeß, in welchem sie in Strömungsrichtung aufgebogen und das Blech 38 entlang der strichlierten Biegekanten 27 U-förmig gebogen wird, eine unterschiedliche Höhe aufweisen.

Die in den Figuren 6 bis 10 gezeigten Varianten für Rippen 12 bzw. Richtungsstege 23 und Durchgangsöffnungen 13 können auch bei C- und L-förmigen Profilschienen 11 ausgebildet werden.

Fig. 11 zeigt ausschnittsweise ein Lochblech 41, welches für eine U-förmige Rippenschiene 11 zugeschnitten ist und im Bereich der Schienenschenkel 14, 15 mit einer Vielzahl von Löchern als Durchgangsöffnungen 13 und Stegen als Rippen 12 versehen ist. Der Mittelsteg 17 ist im Ausführungsbeispiel gemäß Fig. 11 kompakt und nahezu ohne Durchgangsöffnungen 13 ausgebildet. Grundsätzlich können die Löcher bzw. Durchgangsöffnungen 13 auch in diesem Bereich vorgesehen werden.

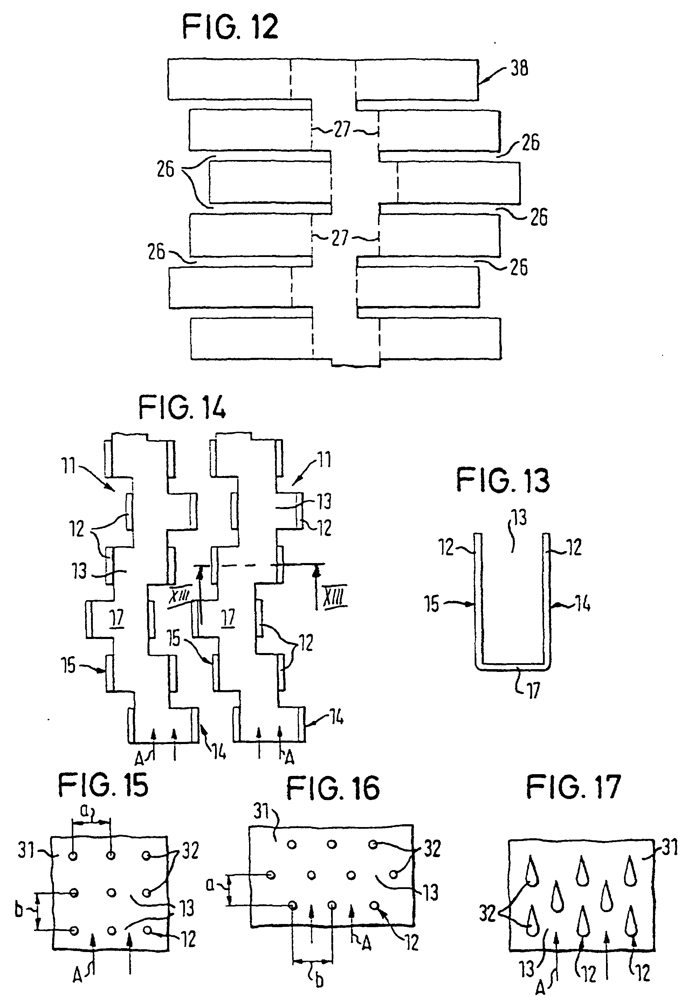

Die Figur 12 zeigt einen Ausschnitt eines Blechzuschnitts 38 für eine U-förmige Profilschiene 11 gemäß Fig. 13 und 14, welche vertikal angeordnet wird. Zum besseren Verständnis sind in Fig. 14 zwei derartige Profilschienen 11 nebeneinander angeordnet. Rippen 12 sind durch Randausnehmungen 26 ausgebildet, welche jeweils bis zu einer versetzt angeordneten Biegekante 27 reichen, und Durchgangsöffnungen 13 sind durch die Räume zwischen den Rippen 12 gebildet, welche in Strömungsrichtung (Pfeile A) versetzt angeordnet sind. Die Profilschienen 11 weisen gestuft ausgebildete Schienenschenkel 14, 15 mit Rippen 12 auf und sind in Fig. 14 komplementär zueinander angeordnet.

Alternativ zu U-,C- oder L-förmigen Profilschienen können Rippenschienen 11 mit Rippen 12 und Durchgangsöffnungen 13 durch Stifte 32, welche mit einem vorgegebenen Abstand an einen Befestigungssteg 31 angeordnet werden, gebildet werden. Der Befestigungssteg 31 ist schienenartig ausgebildet und reicht nahezu über die Breite einer Funktionsraumwand. Eine Vielzahl von Stiften 32 als Rippen 12 sind in einer in Strömungsrichtung (siehe Pfeile A) fluchtenden Anordnung (Fig. 15) oder in einer versetzten Anordnung (Fig. 16) befestigt, z.B. mittels Schweißen, Nieten, Kleben, Toxen oder Löten. Die Rippen 12 bzw. Stifte 32 können mit einer Querteilung a an dem Befestigungssteg 31 befestigt sein, welche einer Längsteilung b entspricht oder aber von dieser abweicht.

Die stiftartigen Rippen 12 können die in den Figuren 15 und 16 gezeigten kreisförmigen Querschnitte, jedoch auch einen rechteckigen, quadratischen oder polygonalen oder den in Fig. 17 gezeigten stromlinienförmigen Querschnitt aufweisen.

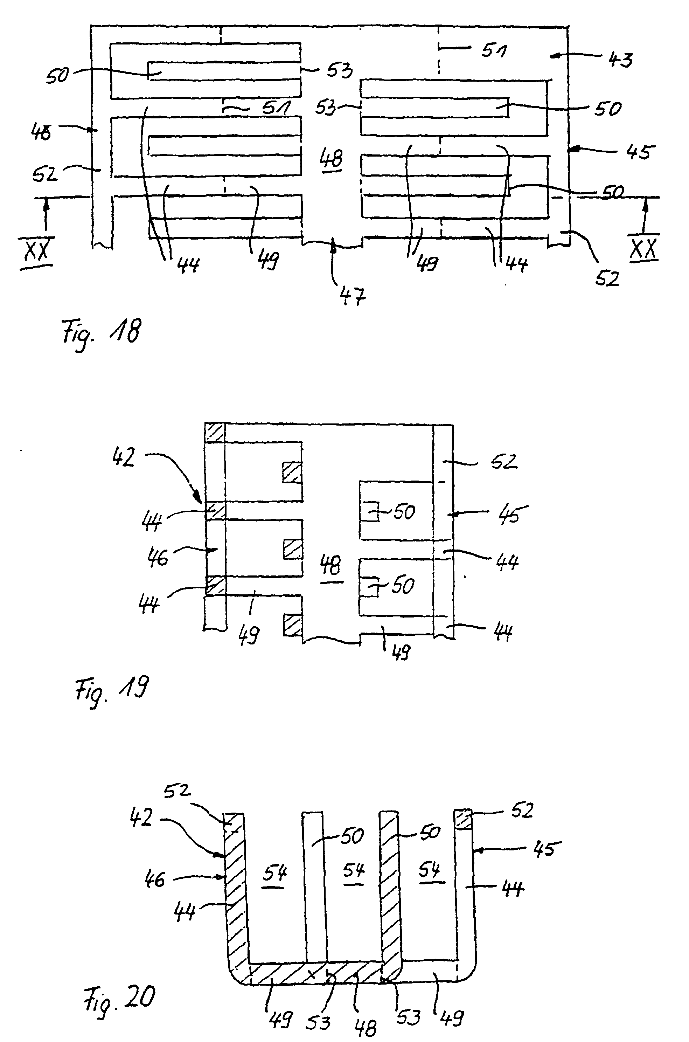

In den Fig. 18 bis 20 ist eine sogenannte "Doppelrippenschiene" gezeigt. Die Doppelrippenschiene 42 weist im Vergleich zu der Rippenschiene 11 der Figuren 1 bis 5 vier Reihen mit Rippen auf und kann aus einem gestanzten Blech 43 gebildet, von welchem ein Ausschnitt in Fig. 18 gezeigt ist, durch einen Biegeprozeß hergestellt werden. Das gestanzte Blech 43 bzw. die daraus hergestellte Doppelrippenschiene 42 weist einen Mittelsteg 47 auf, welcher aus einem durchgehenden Stegbereich 48 und Anschlußbereichen 49 gebildet wird und welcher im befestigten Zustand der Doppelrippenschiene 42 an einer Funktionsraumwand 6 (siehe Fig. 1) anliegt. Die Anschlußbereiche 49 werden von Rippen 44 der Schienenschenkel 45 und 46 gebildet, welche an strichliert dargestellten Biegekanten 51 umgebogen werden. Die zusätzlichen Rippen, welche als Mittelrippen 50 bezeichnet werden, werden an Biegekanten 53 des durchgehenden Mittelstegs 48 umgebogen.

Insbesondere Fig. 20 verdeutlicht, daß die "Doppelrippenschienen" 42 besonders effizient hergestellt und an einer Funktionsraumwand eines Geräteschrankes, eines Wärmetauschers und dergleichen befestigt werden können. Ein an den äußeren Schienenschenkeln 45, 46 vorhandener Außensteg 52 dient der Stabilität der Doppelrippenschiene 42. Die Fluidströmung wird in Zwischenräumen 54 zwischen den Rippen 44 der Schienenschenkel 45, 46 und den reihenartig ausgerichteten Mittelrippen 50 geführt und durch Durchgangsöffnungen 55 zusätzlich verwirbelt.

## Patentansprüche

1. Geräteschrank für elektrische und elektronische Geräte und Bauteile, mit einem Funktionsraum (3), welcher von einer Wand (4) und wenigstens einer Tür umgeben und staub- und wasserdicht abgeschlossen ist, wobei die Wand (4) mehrschalig ausgebildet ist und wenigstens eine Außenwand (5), eine Funktionsraumwand (6) mit einer Berippung (10) für eine Verwirbelung einer Fluidströmung und einen besseren Warmeübergang und eine innenseitige Leitwand (7) aufweist, welche einen Innenkanal (8) und einen Außenkanal (9) für voneinander unabhängige Fluidströme (18, 19) zur Kühlung und Temperierung des Funktionsraums (3) bilden,
**dadurch gekennzeichnet,**
**daß** zur Berippung (10) der Funktionsraumwand (6) Rippenschienen (11) vorgesehen sind,
**daß** die Rippenschienen (11) an der Funktionsraumwand (6) angeordnet sind und
**daß** die Rippenschienen (11) eine Vielzahl von Rippen (12) aufweisen, zwischen welchen Durchgangsöffnungen (13) für den Fluidstrom (18, 19) gebildet sind.

2. Geräteschrank nach Anspruch 1,
**dadurch gekennzeichnet,**
**daß** die Rippenschienen (11) horizontal oder vertikal und nahezu über die gesamte Höhe an der Funktionswand (6) befestigt sind.

3. Geräteschrank nach Anspruch 1 oder 2,
**dadurch gekennzeichnet,**
**daß** die Rippenschienen (11) an der Innen- und Außenseite der Funktionsraumwand (6) befestigt und in gleicher Höhe oder versetzt zueinander angeordnet sind.

4. Geräteschrank nach einem der vorhergehenden Ansprüche,
**dadurch gekennzeichnet,**
**daß** die Rippenschienen (11) U- oder C-förmig ausgebildet und in einem beliebigen Abstand voneinander über- oder nebeneinander , insbesondere in einem etwa der Höhe bzw. Breite der Rippenschiene (11) entsprechenden Abstand, angeordnet sind.

5. Geräteschrank nach Anspruch 4,
**dadurch gekennzeichnet,**
**daß** die Rippenschiene (11) einen unteren Schienenschenkel (14) und einen oberen Schienenschenkel (15) aufweist, welche mit den Rippen (12) und Durchgangsöffnungen (13) versehen sind, und daß zur Anlage und Befestigung an der Innen- und/oder Außenseite der Funktionsraumwand (6) ein Mittelsteg (17) ausgebildet ist, welcher etwa rechtwinklig zu den Schienenschenkeln (14, 15) ausgerichtet ist.

6. Geräteschrank nach Anspruch 5,
**dadurch gekennzeichnet,**
**daß** die Rippen (12) und Durchgangsöffnungen (13) des unteren und oberen Schienenschenkels (14, 15) miteinander fluchten oder versetzt zueinander ausgebildet sind.

7. Geräteschrank nach einem der vorhergehenden Ansprüche,
**dadurch gekennzeichnet,**
**daß** die Rippenschiene (11) mit den Rippen (12) und Durchgangsöffnungen (13) durch einen Stanz- und Biegeprozeß hergestellt ist.

8. Geräteschrank nach einem der vorhergehenden Ansprüche,
**dadurch gekennzeichnet,**
**daß** die Rippen (12) als Richtungsstege (23) ausgebildet oder die Durchgangsbohrungen (13) mit Richtungsstegen (23) versehen sind und daß die Richtungsstege (23) durch auf- oder abgebogene oder auf- oder abgewinkelte Stanzbereiche (29) gebildet sind.

9. Geräteschrank nach Anspruch 8,
**dadurch gekennzeichnet,**
**daß** die Richtungsstege (23) einer Rippenschiene (11) oder eines Rippenschenkels (14, 15) in Strömungsrichtung gebogen oder abgewinkelt sind.

10. Geräteschrank nach einem der vorhergehenden Ansprüche,
**dadurch gekennzeichnet,**
**daß** die Rippen (12) und Durchgangsöffnungen (13) durch Schnitte oder Schlitze (24) und nachfolgendes Biegen der Stanzbereiche (29) um eine Drehachse (28), welche mittig oder außermittig angeordnet ist, gebildet sind.

11. Geräteschrank nach einem der vorhergehenden Ansprüche,
**dadurch gekennzeichnet,**
**daß** die Rippen (12) und Durchgangsöffnungen (13) der Rippenschiene (11) durch Stanzbereiche (29) mit Ausstanzungen (30) gebildet sind.

12. Geräteschrank nach einem der Ansprüche 1 bis 7,
**dadurch gekennzeichnet,**
**daß** die Rippen (12) durch Randausnehmungen (26), welche bis zu einer versetzten Biegekante (27) reichen, und die Durchgangsöffnungen (13) zwischen Breitseiten der Rippen (12) ausgebildet sind.

13. Geräteschrank nach einem der Ansprüche 1 bis 7,
**dadurch gekennzeichnet,**
**daß** die Rippenschiene (11) oder wenigstens die Schienenschenkel (14, 15) aus einem Lochblech (41) gefertigt sind.

14. Geräteschrank nach einem der Ansprüche 1 bis 7,
**dadurch gekennzeichnet,**
**daß** die Rippenschiene (11) als eine Doppelrippenschiene (42) ausgebildet ist und zusätzlich zu Rippen (44) von Schienenschenkeln (45, 46) Mittelrippen (50) aufweist.

15. Geräteschrank nach Anspruch 14,
**dadurch gekennzeichnet,**
**daß** die Doppelrippenschiene (42) einen Mittelsteg (47) aufweist, welcher aus einem durchgehenden Stegbereich (48) und Anschlußbereichen (49) der Schienenschenkel (45, 46) besteht, und daß von den Rippen (44) der außenseitig ausgebildeten Schienenschenkel (45, 46) und den Mittelrippen (50) Zwischenräume (54) und Durchgangsöffnungen (55) für eine Fluidströmung gebildet sind.

16. Geräteschrank nach einem der Ansprüche 1 bis 3, 6 bis 13,
**dadurch gekennzeichnet,**
**daß** die Rippenschiene (11) L-förmig ausgebildet ist und einen vertikalen Befestigungssteg (31) und einen horizontalen Schienenschenkel (14) aufweist.

17. Geräteschrank nach einem der vorhergehenden Ansprüche 1 bis 3,
**dadurch gekennzeichnet,**
**daß** die Rippenschiene (11) einen plättenförmigen Befestigungssteg (31) aufweist, an welchem eine Vielzahl von Stiften (32) als Rippen durch Kleben, Schweißen, Löten oder Toxen angebracht sind,
**daß** die Stifte (32) einen runden, rechteckigen, quadratischen oder stromlinienförmigen Querschnitt aufweisen und fluchtend oder versetzt mit gleicher oder unterschiedlicher Quer- und Längsteilung befestigt sind.

18. Geräteschrank nach einem der vorhergehenden Ansprüche,
**dadurch gekennzeichnet,**
**daß** die Rippenschienen (11) und Doppelrippenschienen (42) mittels Kleben, Schweißen, Löten oder Toxen befestigt sind.

## Claims

1. Equipment cabinet for electrical and electronic equipment and components, with a functional area (3), which is surrounded and terminated in dustproof and watertight manner by a wall (4) and at least one door, in which the wall (4) has a multishell construction and has at least an outer wall (5), a functional area wall (6) with a rib system (10) for a turbulence of a fluid flow and a better heat transfer and an inside guide wall (7), which form an inner channel (8) and an outer channel (9) for independent fluid flows (18, 19) for cooling and temperature control of the functional area (3),
**characterized in that**
rib rails (11) are provided for the rib system (10) of the functional area wall (6),
that the rib rails (11) are located on the functional area wall (6) and
that the rib rails (11) have a plurality of ribs (12), between which are formed through ports (13) for the fluid flow (18, 19).

2. Equipment cabinet according to claim 1,
**characterized in that**
the rib rails (11) are fixed horizontally or vertically over virtually the entire height to the functional area wall (6).

3. Equipment cabinet according to claim 1 or 2,
**characterized in that**
the rib rails (11) are fixed to the inside and outside of the functional area wall (6) and are arranged at the same height or in mutually displaced manner.

4. Equipment cabinet according to one of the preceding claims,
**characterized in that**
the rib rails (11) are U- or C-shaped and arranged with a random spacing, particularly with a spacing roughly corresponding to the height of the rib rail (11).

5. Equipment cabinet according to claim 4,
**characterized in that**
the rib rail (11) has a lower rail arm (14) and an upper rail arm (15), which are provided with the ribs (12) and the through ports (13), and that for the engagement and fixing to the inside and/or outside of the functional area wall (6) a central web (17) is formed which is roughly arranged in a rectangular manner regarding the rail arms (14, 15).

6. Equipment cabinet according to claim 5,
**characterized in that**
the ribs (12) and through ports (13) of the lower and upper rail arms (14, 15) are aligned with one another or are mutually displaced.

7. Equipment cabinet according to one of the preceding claims,
**characterized in that**
the rib rail (11) with the ribs (12) and through ports (13) is produced by a punching and bending process.

8. Equipment cabinet according to one of the preceding claims,
**characterized in that**
the ribs (12) are constructed as direction webs (23) or the through ports (13) are provided with direction webs (23) and the direction webs (23) are formed by upwardly or downwardly bent or angled punched areas (29).

9. Equipment cabinet according to claim 8,
**characterized in that**
the direction webs (23) of a rib rail (11) or a rib arm (14, 15) are bent or angled in the flow direction.

10. Equipment cabinet according to one of the preceding claims,
**characterized in that**
the ribs (12) and through ports (13) are formed by incisions or slots (24) and subsequent bending of the punched areas (29) about a rotation axis (28), which is positioned centrally or eccentrically.

11. Equipment cabinet according to one of the preceding claims,
**characterized in that**
the ribs (12) and though ports (13) of the rib rail (11) are formed by punched areas (29) with punched-put portions (30).

12. Equipment cabinet according to one of the claims 1 to 7,
**characterized in that**
the ribs (12) are formed by marginal recesses (26), which extend up to an offset bending edge (27), and the through ports (13) are formed between the wide sides of the ribs (12).

13. Equipment cabinet according to one of the claims 1 to 7,
**characterized in that**
the rib rail (11) or at least the rail arms (14, 15) are made from a perforated metal sheet (41).

14. Equipment cabinet according to one of the claims 1 to 7,
**characterized in that**
the rib rail (11) is constructed as a double rib rail (42) which has rail arms (45, 46) with ribs (44) and which is additionally provided with middle ribs (50).

15. Equipment cabinet according to claim 14,
**characterized in that**
the double rail (42) has a central web (47) consisting of an uninterrupted web area (48) and connecting areas (49) of the rail arms (45, 46) and that spaces (54) and through ports (54) are formed by the ribs (44) of the rail arms (45, 46) being outwardly formed and the middle ribs (50) for a fluid flow.

16. Equipment cabinet according to one of the claims 1 to 3 and 6 to 13,
**characterized in that**
the rib rail (11) is L-shaped and has a vertical fixing web (31) and a horizontal rail arm (14).

17. Equipment cabinet according to one of the preceding claims 1 to 3,
**characterized in that**
the rib rail (11) has a flat fixing web (31), to which are fitted by bonding, welding, soldering or clinching a plurality of pins (32) as webs, that the pins (32) have a round, rectangular, square or streamlined cross-section and are fixed in aligned or offset manner with an identical or differing transverse and longitudinal spacing.

18. Equipment cabinet according to one of the preceding claims,
**characterized in that**
the rib rails (11) and double rib rails (42) are fixed by bonding, welding, soldering or clinching.

## Revendications

1. Armoire pour appareils et modules électriques et électroniques, comportant un espace fonctionnel (3) entouré d'une paroi (4) et d'au moins une porte et fermé de façon à être étanche à la poussière et à l'eau, la paroi (4) étant constituée de façon multicoque et présentant au moins une paroi extérieure (5), une paroi d'espace fonctionnel (6) avec un nervurage (10) pour faire tourbillonner un écoulement de fluide et pour un meilleur transfert de la chaleur et une paroi de guidage intérieure (7) qui forment un canal intérieur (8) et un canal extérieur (9) pour des écoulements de fluide (18, 19) indépendants l'un de l'autre pour le refroidissement et la climatisation de l'espace fonctionnel (3),
**caractérisée en ce que**
des rails à nervures (11) sont prévus pour le nervurage (10) de la paroi de l'espace fonctionnel (6),
les rails à nervures (11) sont disposés sur la paroi de l'espace fonctionnel (6) et
les rails à nervures (11) présentent une multitude de nervures (12) entre lesquelles sont formées des ouvertures de traversée (13) pour l'écoulement de fluide (18, 19).

2. Armoire selon la revendication 1,
**caractérisée en ce que**
les rails à nervures (11) sont fixés sur la paroi d'espace fonctionnel (6) horizontalement ou verticalement et quasiment sur la totalité de la hauteur.

3. Armoire selon la revendication 1 ou 2,
**caractérisée en ce que**
les rails à nervures (11) sont fixés sur le côté intérieur ou extérieur de la paroi d'espace fonctionnel (6) et sont disposés à la même hauteur et décalés les uns par rapport aux autres.

4. Armoire selon l'une quelconque des revendications précédentes,
**caractérisée en ce que**
les rails à nervures (11) sont en forme de U ou de C et disposés selon un écartement quelconque les uns par rapport aux autres, les uns au-dessus des autres, respectivement les uns à côté des autres, en particulier selon un écartement correspondant sensiblement à la hauteur ou à la largeur des rails à nervures (11).

5. Armoire selon la revendication 4,
**caractérisée en ce que**
le rail à nervures (11) présente une hampe de rail inférieure (14) et une hampe de rail supérieure (15) qui sont pourvues des nervures (12) et d'ouvertures de passage (13), et pour la disposition et la fixation sur le côté intérieur et/ou extérieur de la paroi d'espace fonctionnel (6), une entretoise médiane (17) est formée orientée sensiblement perpendiculairement par rapport aux hampes de rail (14, 15).

6. Armoire selon la revendication 5,
**caractérisée en ce que**
les nervures (12) et les ouvertures de passage (13) de la hampe de rail inférieure et supérieure (14, 15), affleurent les unes avec les autres ou sont configurées en décalage les unes par rapport aux autres.

7. Armoire selon l'une quelconque des revendications précédentes,
**caractérisée en ce que**
le rail à nervures (11), avec les nervures (12) et les ouvertures de passage (13), est réalisé par un processus d'emboutissage et de pliage.

8. Armoire selon l'une quelconque des revendications précédentes,
**caractérisée en ce que**
les nervures (12) sont configurées en tant qu'entretoises directionnelles (23) ou les perçages de passage (13) sont pourvus d'entretoises directionnelles (23) et que les entretoises directionnelles (23) sont formées de zones embouties (29) pliées vers le haut ou vers le bas ou coudées vers le haut ou vers le bas.

9. Armoire selon la revendication 8,
**caractérisée en ce que**
les entretoises directionnelles (23) d'un rail à nervures (11) ou d'une hampe à nervures (14, 15) sont pliées ou coudées en direction de l'écoulement.

10. Armoire selon l'une quelconque des revendications précédentes,
**caractérisée en ce que**
les nervures (12) et ouvertures de passage (13) sont formées par des coupes ou des fentes (24) et un pliage consécutif de la zone d'emboutie (29) autour d'un axe de rotation (28) disposé de façon centrée ou excentrée.

11. Armoire selon l'une quelconque des revendications précédentes,
**caractérisée en ce que**
les nervures (12) et ouvertures de passage (13) du rail à nervure (11) sont formées par des zones embouties (29) avec découpures (30) à la presse.

12. Armoire selon l'une quelconque des revendications 1 à 7,
**caractérisée en ce que**
les nervures (12) sont formées par des creux de bord (26) qui s'étendent jusqu'à une arête de pliage décalée (27) et les ouvertures de passage (13) sont formées entre des côtés larges des nervures (12).

13. Armoire selon l'une quelconque des revendications 1 à 7,
**caractérisée en ce que**
le rail à nervures (11) ou au moins les hampes de rail (14, 15) sont réalisés à partir d'une tôle perforée (41).

14. Armoire selon l'une quelconque des revendications 1 à 7,
**caractérisée en ce que**
le rail à nervures (11) est constitué en tant que rail à nervures doubles (42) et, en plus des nervures (44) des hampes de rail (45, 46), présente des nervures médianes (50).

15. Armoire selon la revendication 14,
**caractérisée en ce que**
le rail à nervures doubles (42) présente une entretoise médiane (47) qui se constitue d'une zone continue d'entretoises (48) et de zones de raccordement (49) des hampes de rail (45, 46), et les espaces intermédiaires (54) et les ouvertures de passage (55) pour un écoulement de fluide sont formés par les nervures (44) des hampes de rail (45, 46) constituées côté extérieur et les nervures médianes (50).

16. Armoire selon l'une quelconque des revendications 1 à 3, 6 à 13,
**caractérisée en ce que**
le rail à nervures (11) est en forme de L et présente une entretoise de fixation verticale (31) et une hampe de rail horizontale (14).

17. Armoire selon l'une des revendications précédentes 1 à 3,
**caractérisée en ce que**
le rail à nervures (11) présente une entretoise de fixation (31) en forme de plaque à laquelle est apportée par collage, soudage, brasure ou sertissage une multitude de chevilles (32) en tant que nervures,
les chevilles (32) présentent une section transversale ronde, rectangulaire, carrée ou profilée et sont fixées en affleurement ou décalées avec un écartement longitudinal ou transversal semblable ou différent.

18. Armoire selon l'une quelconque des revendications précédentes,
**caractérisée en ce que**
les rails à nervures (11) et les rails à nervures doubles (42) sont fixés par collage, soudage, brasure ou sertissage.
